# EUROPÄISCHE PATENTSCHRIFT

(11) **EP 2 841 821 B1**
(45) Veröffentlichungstag und Bekanntmachung des Hinweises auf die Patenterteilung: **11.05.2016**
(21) Anmeldenummer: 13707153.6
(22) Anmeldetag: 27.02.2013
(51) Int. Cl.: F16J 15/06, H05K 7/00

(54) **VORRICHTUNG MIT EINEM ZWISCHEN EINEM ERSTEN BAUTEIL UND EINEM ZWEITEN BAUTEIL ANGEORDNETEN ELASTISCHEN DICHTUNGSTEIL UND VERFAHREN ZUR HERSTELLUNG EINER SOLCHEN VORRICHTUNG**
DEVICE WITH AN ELASTIC SEALING PART ARRANGED BETWEEN A FIRST COMPONENT AND A SECOND COMPONENT, AND METHOD FOR PRODUCING SUCH A DEVICE
DISPOSITIF COMPORTANT UN JOINT ÉLASTIQUE DISPOSÉ ENTRE UNE PREMIÈRE PIÈCE ET UNE DEUXIÈME PIÈCE, ET PROCÉDÉ DE FABRICATION D'UN TEL DISPOSITIF.

(30) Priorität: 27.04.2012 DE 102012207057
(43) Veröffentlichungstag der Anmeldung: 04.03.2015
(73) Patentinhaber: Robert Bosch GmbH, 70442 Stuttgart (DE)
(72) Erfinder: WINTER, Falko, 71706 Markgroeningen (DE)
(86) Internationale Anmeldenummer: PCT/EP2013/053847
(87) Internationale Veröffentlichungsnummer: WO 2013/159956

(56) Entgegenhaltungen:
- DE-A1-102007 029 913
- US-A1- 2009 033 111
- US-A1- 2010 112 118

## Beschreibung

### Stand der Technik

Die Erfindung betrifft eine Vorrichtung, insbesondere für ein elektronisches Steuergerät, mit den Merkmalen des Oberbegriffs des unabhängigen Vorrichtungsanspruchs und ein Verfahren zur Herstellung einer solchen Vorrichtung.

Beim Einsatz von elektronischen Geräten, z.B. in Steuergeräten für den Einsatz in Kraftfahrzeugen, ist es oft erforderlich, die elektronischen Komponenten gegen äußere Medien zu schützen. Häufig werden zu diesem Zweck die elektronischen Komponenten in einem gegen die äußeren Medien dichten Gehäuse mit beispielsweise zwei Bauteilen angeordnet. In der DE 10 2007 029 913 A1 wird dabei zur Herstellung der Dichtheit als ein erstes Bauteil ein Gehäusedeckel auf ein zweites Bauteil, das hierbei durch eine Leiterplatte ausgeführt ist, befestigt und zwischen dem Gehäusedeckel und dem Leiterplatte ein Dichtungsteil in Form eines elastischen Dichtrings angeordnet, der durch den Gehäusedeckel an die Leiterplatte dichtgepresst wird.

Bei der Fertigung des Gehäuses sollte das Dichtungsteil verliersicher und positionsgenau an einem der beiden Bauteile festgelegt werden, bevor das Abdichten des Gehäuses durch Dichtpressen der zweiten Komponente auf das Dichtungsteil sichergestellt wird. Verrutscht das Dichtungsteil bei Bewegungen der Komponenten in einem Fertigungszwischenschritt (beispielsweise auf einem Transportband) oder geht es verloren, so ist die Dichtheit des Gehäuses nicht gewährleistet und der vom Gehäuse umgebene Bereich kann durch eindringende Medien in seiner Funktionsweise beeinträchtigt oder sogar zerstört werden. Montiert man das Dichtungsteil dagegen erst unmittelbar beim Zusammenführen der Bauteile, so muss das Dichtungsteil positionsgenau befestigt werden, damit zumindest eine horizontale Bewegung eines der beiden Bauteile die Position des Dichtungsteils nicht verändern kann

Zur Erzielung der Verliersicherheit und der Positioniergenauigkeit kann eine konstruktive Maßnahme an wenigstens einem der wenigstens zwei Bauteile vorgesehen sein, beispielsweise in Form einer Nut, in die das Dichtungsteil eingelegt werden muss oder in Form von Haltestrukturen, z.B. Zapfen, die das Dichtungselement positionsgenau und verliersicher an einem der Bauteile festlegen. Die Einbringung einer Nut oder von Haltestrukturen in einem der Bauteile, sowie das anschließende Einlegen des Dichtungsteils in die Nut bzw. um die Haltestrukturen herum sind Zusatzschritte, die relativ aufwändig sind. Darüber hinaus reduziert das Einbringen einer Nut oder von Haltestrukturen in z.B. einen Schaltungsträger, insbesondere eine Leiterplatte, die Fläche, die für Leiterbahnen auf dem Schaltungsträger genutzt werden kann.

Das Dichtungsteil kann auch im Gehäusedeckel angebracht werden. Oft ist der Gehäusedeckel das kleinere und leichtere Bauteil verglichen mit dem bestückten Schaltungsträger. Bei einer Montage des Gehäusedeckels von oben auf den Schaltungsträger muss dann sichergestellt werden, dass das im Gehäusedeckel angebrachte Dichtungsteil bei der Montage nicht nach unten heraus fällt.

Die gattungsgemäße US 2010/0112118 A1 zeigt eine Verbindung von zwei Körpern durch ein zwischen den zwei Körpern angeordnetes Dichtungsteil.

Die US 2009/003311 A1 zeigt eine Anhebevorrichtung für ein Vakuumtransfersystem, das ein als Saugnapf dienendes Dichtungsteil aufweist.

### Offenbarung der Erfindung

### Vorteile der Erfindung

Gegenüber dem Stand der Technik weist die Vorrichtung mit den Merkmalen des unabhängigen Anspruchs den Vorteil auf, dass eine verliersichere und positionsgenaue Montage des Dichtungsteils einfach und kostengünstig an einem der Bauteile gewährleistet ist.
Vorteilhaft weist die Vorrichtung, insbesondere für ein elektronisches Steuergerät, wenigstens ein erstes Bauteil und wenigstens ein zweites Bauteil und wenigstens ein zwischen dem wenigstens einen ersten Bauteil und dem wenigstens einen zweiten Bauteil angeordnetes elastisches Dichtungsteil auf, wobei das erste Bauteil an einer ersten Oberfläche des wenigstens einen elastischen Dichtungsteils anliegt und eine zweite Oberfläche des wenigstens einen elastischen Dichtungsteils an dem zweiten Bauteil anliegt. Vorteilhaft ist das wenigstens eine elastische Dichtungsteil mit Mitteln zur Erzielung einer Unterdruckhaftung des wenigstens einen elastischen Dichtungsteils an dem zweiten Bauteil versehen. Erfindungsgemäß wird vorgeschlagen, dass das elastische Dichtungsteil wenigstens einen Dichtungsabschnitt und wenigstens einen elastischen Ausleger aufweist, wobei der wenigstens eine Dichtungsabschnitt in einem Dichtungsbereich zwischen dem ersten Bauteil und dem zweiten Bauteil anliegt und der wenigstens eine elastische Ausleger außerhalb des Dichtungsbereichs an dem zweiten Bauteil zur Anlage kommt und die Mittel zur Erzielung einer Unterdruckanhaftung an dem wenigstens einen elastischen Ausleger des elastischen Dichtungsteils angeordnet sind. Dadurch wird vorteilhaft erreicht, dass das elastische Dichtungsteil einerseits positionsgenau und verliersicher auf dem zweiten Bauteil angeordnet werden kann und gleichzeitig das elastische Dichtungsteil im Bereich des wenigstens einen Dichtungsabschnitts eine nicht durch die Mittel und/oder Ausnehmungen veränderte Form aufweist. Dies bewirkt vorteilhaft eine besonders sichere und dauerhafte Dichtheit.
Das zweite Bauteil ist dabei beispielsweise ein Schaltungsträger, insbesondere eine Leiterplatte und weist vorzugsweise eine ebene, glatte Oberfläche auf.

Die Unterdruckhaftung des elastischen Dichtungsteils an dem zweiten Bauteil bewirkt vorteilhaft, dass das elastische Dichtungsteil auf dem zweiten Bauteil auch beim Einwirken mechanischer Einflüsse im Fertigungsprozess, beispielsweise durch Rütteln oder Vibrationen auf einem Transportband oder beim Über-Kopf-Drehen des zweiten Bauteils, an dem zweiten Bauteil positionsgenau haften bleibt, also beispielsweise nicht verrutscht und auch nicht verloren gehen kann. Die Montage des ersten Bauteils durch Dichtpressen auf dem an der richtigen Position befindlichen elastischen Dichtungsteil stellt dann die Dichtheit der Vorrichtung gegen äußere Medien sicher.

Vorteilhafterweise wird durch die Erfindung weiterhin eine sichere Abdichtung der Vorrichtung erzielt, die robust gegen Einflüsse des Fertigungsprozesses nach Montage des Dichtungsteils ist und die ohne aufwändige Zusatzschritte in der Montage oder in der Konstruktion der Bauteile bewirkt wird.

Vorteilhafte Ausbildungen und Weiterentwicklungen der Erfindung werden durch die in den abhängigen Ansprüchen angegebenen Maßnahmen ermöglicht. Eine besonders vorteilhafte Ausführungsform der Erfindung ergibt sich dadurch, dass die Mittel zur Erzielung einer Unterdruckhaftung wenigstens eine eine Druckkammer bildende Ausnehmung aufweisen, in der ein Unterdruck (ein gegenüber dem Umgebungsdruck, z.B. Atmosphärendruck, geringerer Druck) erzeugbar ist, durch den das wenigstens eine elastische Dichtungsteil an dem zweiten Bauteil anhaftet.

Eine vorteilhafte Weiterbildung der Erfindung, wird dadurch erreicht, dass der Unterdruck in der wenigstens einen Druckkammer durch Anpressen und Relaxieren des elastischen Dichtungsteils erzeugbar ist. Dies ermöglicht gegenüber dem Stand der Technik vorteilhaft eine besonders einfache Montage des elastischen Dichtungsteils auf dem zweiten Bauteil, da die Schritte des Anpressens und des Relaxierens mit dem Positionierschritt gekoppelt werden können. Der nach dem Relaxieren erzeugte Unterdruck gegenüber dem Umgebungsdruck, der das elastische Dichtungsteil umgibt, lässt dabei das elastische Dichtungsteil positionsgenau auf dem zweiten Bauteil haften.

Dadurch, dass sich die wenigstens eine Ausnehmung in der zweiten Oberfläche des elastischen Dichtungsteils befindet, wird vorteilhaft eine besonders raumsparende Ausführungsform der Erfindung bewirkt. Dabei ist im Sinne der Erfindung als die zweite Oberfläche des elastischen Dichtungsteils die Oberfläche zu verstehen, die dem zweiten Bauteil zugewandt ist. Die von der zweiten Oberfläche des elastischen Dichtungsteils abgewandte erste Oberfläche ist dagegen in der fertig montierten Vorrichtung dem ersten Bauteil zugewandt. Die wenigstens eine Ausnehmung kann dabei im Herstellungsprozess des elastischen Dichtungsteils bereits bei der Formgebung des elastischen Dichtungsteils erzeugt werden, die wenigstens eine Ausnehmung kann jedoch auch erst nach Herstellung des elastischen Dichtungsteils durch Materialentfernung aus dem elastischen Dichtungsteils realisiert werden. Ferner vereinfacht sich in vorteilhafter Weise der Montageprozess des elastischen Dichtungsteils auf dem zweiten Bauteil durch die Anordnung der wenigstens einen Ausnehmung in der zweiten Oberfläche des elastischen Dichtungsteil, da dadurch das Positionieren des elastischen Dichtungsteils auf dem zweiten Bauteil und das Anpressen und Relaxieren des elastischen Dichtungsteils in einem Fertigungsschritt ausgeführt werden kann. Dies verringert vorteilhaft das Risiko eines Positionsverlustes des elastischen Dichtungsteils zwischen dem Positionierschritt und dem Schritt des Anpressens und des Relaxierens.

Erfindungsgemäß kann das erste Bauteil der Vorrichtung ein Gehäusedeckel und das zweite Bauteil ein Schaltungsträger sein, insbesondere eine Leiterplatte. In dieser vorteilhaften Ausführung wird das elastische Dichtungsteil auf die bevorzugt ebene und glatte Oberfläche des Schaltungsträgers, insbesondere der Leiterplatte durch Unterdruckhaftung montiert, bevor das erste Bauteil als Gehäusedeckel montiert wird.

Ebenso ist es möglich, dass das erste Bauteil ein Schaltungsträger, insbesondere eine Leiterplatte ist und das zweite Bauteil ein Gehäusedeckel ist. In diesem vorteilhaften Ausführungsbeispiel wird das elastische Dichtungsteil zunächst mittels Unterdruckhaftung am Gehäusedeckel montiert und anschließend zusammen mit dem Gehäusedeckel so auf den das erste Bauteil darstellenden Schaltungsträger montiert, dass das elastische Dichtungsteil zwischen dem Gehäusedeckel und dem Schaltungsträger angeordnet ist und die Vorrichtung gegen äußere Medien abdichtet.

Dadurch, dass das erste Bauteil ein wenigstens eine offene Seite aufweisendes Rohr oder ein Sensorelement ist und das zweite Bauteil eine ebene Fläche, insbesondere eine ebene Fläche mit einer vom elastischen Dichtungsteil umgebenen Öffnung ist, wird vorteilhaft erreicht, dass ein Sensorelement, insbesondere ein Drucksensorelement, dicht gegen die Umgebung auf das erste Bauteil montiert werden kann und das elastische Dichtungsteil vor der Montage des Sensorelements positionsgenau und verliersicher auf dem zweiten Bauteil befestigt ist.

Eine besonders vorteilhafte Ausführungsform der Erfindung wird dadurch erzielt, dass das elastische Dichtungsteil umlaufend ausgebildet ist und einen zwischen dem ersten Bauteil und dem zweiten Bauteil ausgebildeten Gehäuseinnenraum nach außen abdichtet. Vorteilhaft ist ein umlaufend ausgebildetes elastisches Dichtungsteil bei der Montage auf dem zweiten Bauteil besonders einfach zu handhaben und bewirkt vorteilhaft eine dauerhafte Abdichtung der Vorrichtung gegen äußere Medien.

Gegenüber dem Stand der Technik weist das Verfahren mit den Merkmalen des unabhängigen Verfahrensanspruchs den Vorteil auf, dass die Vorrichtung einfacher, kostengünstiger und zuverlässiger hergestellt werden kann. Dies wird erfindungsgemäß dadurch erreicht, dass das wenigstens eine elastische Dichtungsteil mit Mitteln zur Erzielung einer Unterdruckhaftung des wenigstens einen elastischen Dichtungsteils an dem zweiten Bauteil versehen ist und dass das wenigstens eine elastische Dichtungsteil vor dem Schritt des Aufsetzens des ersten Bauteils an dem zweiten Bauteil zur Haftung gebracht wird, indem das wenigstens eine elastische Dichtungsteil auf das zweite Bauteil zunächst angepresst und anschließend relaxiert wird. Dadurch wird vorteilhaft bewirkt, dass das elastische Dichtungsteil auf Grund der Unterdruckhaftung vor dem Schritt des Aufsetzens des ersten Bauteils positionsgenau und verliersicher an dem zweiten Bauteil angeordnet ist, ohne dass es dazu konstruktiver Maßnahmen beispielsweise in Form einer Nut, in Form von Haltezapfen oder dergleichen an dem zweiten und/oder ersten Bauteil bedarf.

Vorteilhaft bewirkt die Erfindung eine Haftung des wenigstens einen elastischen Dichtungsteils an dem zweiten Bauteil, indem beim Anpressen des wenigstens einen elastischen Dichtungsteils auf das zweite Bauteil die Luft aus wenigstens einer eine Druckkammer bildenden Ausnehmung des Dichtungsteils herausgedrückt wird und anschließend die wenigstens eine Ausnehmung durch das elastische Dichtungsteil und das daran anliegende zweite Bauteil derart abgedichtet ist, dass sich in der wenigstens einen Ausnehmung beim Relaxieren des wenigstens einen elastischen Dichtungsteils ein Unterdruck bildet. Dabei erzeugt die Elastizität des Materials des elastischen Dichtungsteils nach dem Anpressen des Dichtungsteils auf das zweite Bauteil eine Rückstellkraft, die das Volumen der zusammengedrückten und luftentleerten wenigstens einen Ausnehmung beim Relaxieren erhöht. Da die wenigstens eine Ausnehmung gegen das zweite Bauteil abgedichtet ist kann bei dieser elastischen Volumenvergrößerung keine Luft in die Ausnehmung einströmen, so dass sich in der Ausnehmung ein Unterdruck ausbildet, verglichen mit dem Umgebungsdruck. Der Unterdruck wird dabei im Wesentlichen bestimmt durch das Kräftegleichgewicht aus elastischer Rückstellkraft und der Unterdruckkraft. Letztere ergibt sich als Produkt aus Wirkfläche und der Druckdifferenz zwischen dem Druck in der Ausnehmung und dem Umgebungsdruck der Vorrichtung, beispielsweise dem Atmosphärendruck.

### Kurze Beschreibung der Zeichnungen

Ausführungsbeispiele der Erfindung sind in den Zeichnungen dargestellt und werden in der nachfolgenden Beschreibung näher erläutert.

Es zeigen:
**Fig. 1a** einen Querschnitt eines Ausführungsbeispiels einer Vorrichtung mit elastischem Dichtungsteil, bei dem sich die Mittel zur Erzielung eines Unterdrucks im elastischen Dichtungsteil befinden;
**Fig. 1b** eine perspektivische Darstellung der dem zweiten Bauteil zugewandten zweiten Oberfläche des elastischen Dichtungsteils aus **Fig. 1a****;**
**Fig. 2a** einen Querschnitt eines Ausführungsbeispiels einer Vorrichtung mit einem elastischem Dichtungsteil, bei dem sich die Mittel zur Erzielung eines Unterdrucks an einem am elastischen Dichtungsteil angeordneten elastischen Ausleger befinden;
**Fig. 2b** eine perspektivische Darstellung der dem zweiten Bauteil zugewandten Oberfläche des elastischen Dichtungsteils und des daran angeordneten elastischen Auslegers aus **Fig. 2a****;**
**Fig. 2c** eine perspektivische Darstellung einer Vorrichtung mit einem elastischen Dichtungsteil mit einem elastischen Ausleger, bevor das erste Bauteil auf das elastische Dichtungsteil aufgesetzt wird;
**Fig. 2d** eine perspektivische Darstellung einer Vorrichtung mit einem elastischen Dichtungsteil mit einem elastischen Ausleger, nachdem das erste Bauteil auf das elastische Dichtungsteil aufgesetzt wurde;
**Fig. 3a** ein elastisches Dichtungsteil, das zwei Dichtungsabschnitte aufweist und ein Verbindungsstück mit einer eine Druckkammer bildenden Ausnehmung,
**Fig. 3b** einen Querschnitt eines Ausführungsbeispiels einer Vorrichtung mit einem elastischem Dichtungsteil mit zwei Dichtungsabschnitten und einem Verbindungsabschnitt, sowie zwei erste Bauteile, die als Rohre ausgebildet sind.

### Ausführungsformen der Erfindung

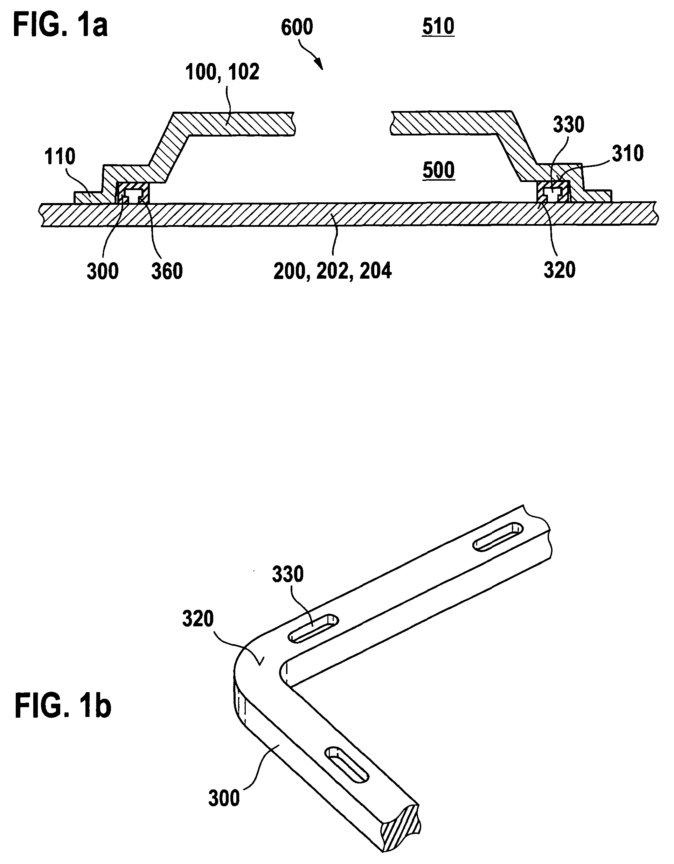

In **Fig. 1a** ist ein Querschnitt eines Ausführungsbeispiels einer Vorrichtung **(600)** mit einem elastischen Dichtungsteil **(300)** dargestellt, bei dem sich die Mittel zur Erzielung eines Unterdrucks im elastischen Dichtungsteil **(300)** befinden. In diesem Ausführungsbeispiel ist das elastische Dichtungsteil **(300)** mit seiner zweiten Oberfläche **(320)** angeordnet auf dem zweiten Bauteil **(200),** das in diesem Ausführungsbeispiel als ein Schaltungsträger **(202),** insbesondere als eine Leiterplatte **(204)** mit ebener und glatter Oberfläche ausgeführt ist. In der zweiten Oberfläche **(320)** des elastischen Dichtungsteils **(300)** befinden sind hierbei Ausnehmungen **(330),** die als Druckkammern wirken. Gegenüber dem Umgebungsdruck, insbesondere dem Atmosphärendruck, herrscht dabei in den Ausnehmungen **(330)** ein Unterdruck, der eine Unterdruckhaftung des elastischen Dichtungsteils **(300)** an dem zweiten Bauteil **(320)** bewirkt (analog zum Saugnapfeffekt). Die die Druckkammern ausbildenden Ausnehmungen **(330)** sind im dargestellten Ausführungsbeispiel als einseitig offene Vertiefungen oder Mulden in die zweite Oberfläche **(320)** des elastischen Dichtungsteils **(300)** eingebracht. Das elastische Dichtungsteil **(300)** bildet den Boden der Ausnehmung **(330),** während die Öffnung der Ausnehmung **(330)** in der zweiten Oberfläche **(320)** des elastischen Dichtungsteils **(300)** angeordnet ist. Die Ausnehmungen **(330)** können dabei in kegelförmiger und/oder zylindrischer und/oder quaderförmiger und/oder runder und/oder einer aus den angeführten Formen zusammengesetzten Form ausgebildet sein. Weiterhin können die Ausnehmungen **(330)** auf der dem zweiten Bauteil **(200)** zugewandten Seite eine elastischen Dichtlippe **(360)** aufweisen, die vorteilhafterweise die Unterdruckhaftung begünstigt. Die Dichtlippe ermöglicht beispielsweise vorteilhaft eine Abdichtung der Unterdruckkammer auch für den Fall, dass die Oberfläche des zweiten Bauteils **(200)** Unebenheiten oder eine gewisse Rauheit aufweist. Die die Druckkammern ausbildenden Ausnehmungen **(330)** können dabei in einer besonders vorteilhaften Ausführung als Saugnapf ausgebildet sein. Die Vorrichtung **(600)** beinhaltet weiterhin ein erstes Bauteil **(100),** das hier als Gehäusedeckel **(102)** ausgeführt ist. Bevorzugt wird der Gehäusedeckel aus Metall oder aus Kunststoff gefertigt. Das erste Bauteil **(100)** weist Befestigungsabschnitte **(110)** auf, mit dem das erste Bauteil **(100)** auf dem zweiten Bauteil **(200)** befestigt werden kann. Die Befestigung des ersten Bauteils **(100)** am zweiten Bauteil **(200)** kann beispielsweise durch Schrauben, Kleben, Klemmen oder Verschweißen, ohne auf eine dieser Möglichkeiten beschränkt zu sein, erfolgen. Durch Dichtpressen des ersten Bauteils **(100)** auf die erste Oberfläche **(310)** des elastischen Dichtungsteils **(300)** wird der Gehäuseinnenraum **(500)** gegen den Außenraum **(510)** abgedichtet.

**Fig. 1b** zeigt eine perspektivische Darstellung der dem zweiten Bauteil **(200)** zugewandten zweiten Oberfläche **(320)** des elastischen Dichtungsteils **(300)** aus **Fig. 1a****.** In der zweiten Oberfläche **(320)** des elastischen Dichtungsteils **(300)** befinden sich dabei Ausnehmungen **(330),** die die Unterdruckhaftung des elastischen Dichtungsteils **(300)** an dem zweiten Bauteil **(200)** bewirken.

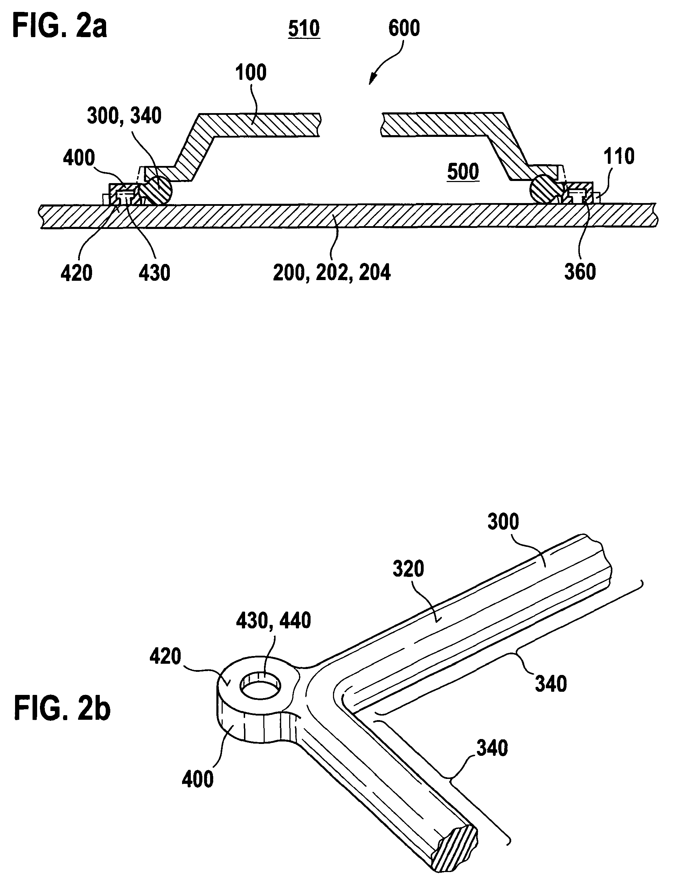

In **Fig. 2a** ist ein Querschnitt eines Ausführungsbeispiels einer Vorrichtung **(600)** mit einem elastischen Dichtungsteil **(300)** dargestellt, bei dem die Mittel zur Erzielung eines Unterdrucks an am elastischen Dichtungsteil **(300)** festgelegten elastischen Auslegern **(400)** angeordnet sind, während die Abdichtung des Innenraums **(500)** der Vorrichtung **(600)** gegenüber dem Außenraum **(510)** durch am elastischen Dichtungsteil **(300)** befindliche Dichtungsabschnitte **(340)** erzielt wird. In diesem Ausführungsbeispiel befinden sich die Mittel zur Erzielung einer Unterdruckhaftung des elastischen Dichtungsteils **(300)** an dem zweiten Bauteil **(200)** in Form von Ausnehmungen **(430)** in der zweiten Oberfläche **(420)** der elastischen Ausleger **(400).** Dabei können die elastischen Ausleger **(400)** einteilig mit dem elastischen Dichtungsteil **(300)** verbunden sein. Ferner können die elastischen Ausleger **(400)** aus demselben Material wie die Dichtungsabschnitte **(340)** des elastischen Dichtungsteils **(300)** hergestellt sein. Es ist jedoch auch möglich, die elastischen Ausleger **(400)** aus einem Material zu fertigen, das sich besonders gut für die Erzielung einer Unterdruckhaftung eignet und die Dichtungsabschnitte **(340)** aus einem anderen Material, das sich besonders gut für die Abdichtung des Innenraums **(500)** eignet. Ein solches Dichtungsteil **(300)** aus wenigstens zwei unterschiedlichen Materialien kann beispielsweise durch ein 2-Komponenten-Spritzgussverfahren hergestellt werden.

Die Befestigung von elastischen Auslegern **(400)** an dem elastischen Dichtungsteil **(300)** im dargestellten Ausführungsbeispiel erlaubt eine Optimierung der Unterdruckhaftung des elastischen Dichtungsteils **(300)** durch zusätzliche konstruktive Freiheitsgrade. Sind beispielsweise nur Teilbereiche der Oberfläche des zweiten Bauteils **(200)** für eine Unterdruckhaftung geeignet, insbesondere glatt und eben ausgebildet, so können die elastischen Ausleger **(400)** so an dem elastischen Dichtungsteil **(300)** angeordnet werden, dass sie bei der Montage auf das zweite Bauteil **(200)** auf eben diesen Oberflächenbereichen des zweiten Bauteils **(200)** zur Anlage kommen. Besonders bevorzugt ist das elastische Dichtungsteil **(300)** mit dem wenigstens einen Ausleger **(400)** einstückig gefertigt. Verglichen mit einer Ausführung, bei der die Mittel zur Erzielung einer Unterdruckhaftung (z.B. Ausnehmungen **(330))** in der zweiten Oberfläche **(320)** des elastischen Dichtungsteils **(300)** angeordnet sind kann durch die elastischen Ausleger **(400)** der Raum vergrößert werden, welcher für Ausnehmungen **(330, 430)** zur Verfügung steht. Durch eine solche Raumvergrößerung wird die Unterdruckhaftung verbessert. Dies bringt insbesondere bei sehr schmalen elastischen Dichtungsteilen **(300)** Vorteile und wirkt sich auch besonders vorteilhaft aus, wenn aufgrund des Materials des elastischen Dichtungsteils **(300)** beim Relaxieren keine größeren Rückstellkräfte auftreten. In einem weiteren Ausführungsbeispiel kann die Unterdruckhaftung dadurch bewirkt werden, dass sowohl Ausnehmungen **(430)** in der zweiten Oberfläche **(420)** des elastischen Auslegers **(400)** als auch Ausnehmungen **(330)** in dem wenigstens einem Dichtungsabschnitt **(340)** des elastischen Dichtungsteils **(300)** vorhanden sind.

**Fig. 2b** zeigt eine perspektivische Darstellung der dem zweiten Bauteil **(100)** zugewandten zweiten Oberfläche **(320)** des elastischen Dichtungsteils **(300)** aus **Fig. 2a****.** Die Figur zeigt dabei die zweite Oberfläche **(420)** mit den in Auslegern **(400)** befindlichen Ausnehmungen **(430),** welche die Unterdruckhaftung des elastischen Dichtungsteils **(300)** an dem zweiten Bauteil **(200)** bewirkend. Die Abdichtung der Vorrichtung **(600)** zwischen dem ersten Bauteil **(100)** und dem zweiten Bauteil **(200)** wird dabei durch die Dichtabschnitte **(340)** des elastischen Dichtungsteils **(300)** bewirkt.

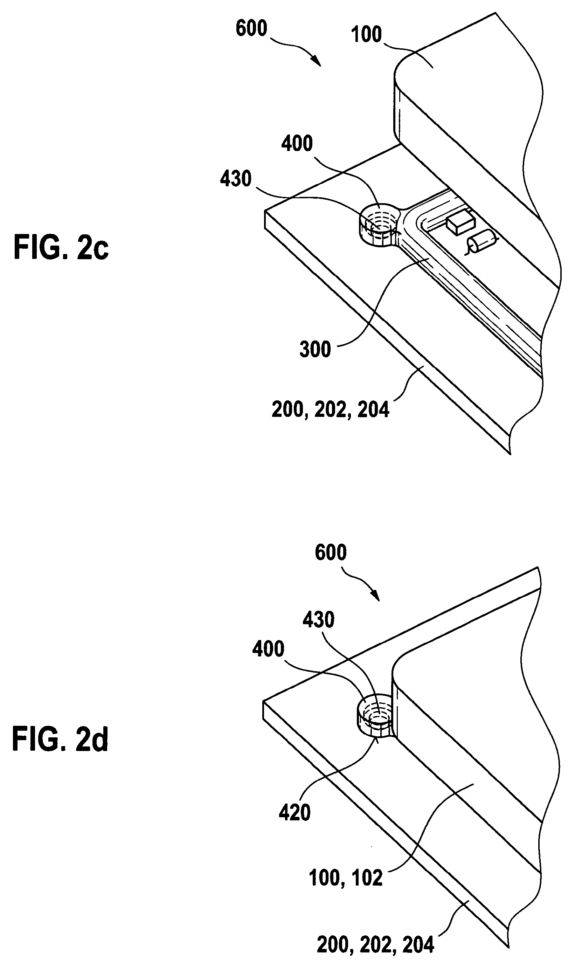

In **Fig. 2c** ist perspektivisch eine Vorrichtung **(600)** vor dem Dichtpressen des ersten Bauteils **(100)** auf das elastische Dichtungsteil **(300)** dargestellt. Das elastische Dichtungsteil (300) ist dabei in einer Ausführungsform zu sehen, bei der die Unterdruckhaftung des elastischen Dichtungsteils **(300)** an dem zweiten Bauteil **(200)** durch an Auslegern **(400)** befindliche Mittel erzielt wird. Das zweite Bauteil **(200)** ist hierbei als eine als Schaltungsträger **(202)** fungierende Leiterplatte **(204)** mit einer ebenen, glatten Oberfläche ausgeführt, an der die elastischen Ausleger **(400)** eine besonders gute Haftung erzielen und so das elastische Dichtungsteil **(300)** positionsgenau, verrutschsicher und verliersicher an dem zweiten Bauteil festlegen, bis das erste Bauteil auf das elastische Dichtungsteil **(300)** dichtgepresst wird.

In **Fig. 2d** ist die Vorrichtung **(600)** im dichtgepressten Zustand dargestellt. Unter dem als Gehäusedeckel **(102)** ausgeführten ersten Bauteil **(100)** ragen in diesem Ausführungsbeispiel nach dem Dichtpressen nur noch die elastischen Ausleger **(400)** hervor, die mit ihrer zweiten Oberfläche an dem zweiten Bauteil durch Unterdruckhaftung anhaften.

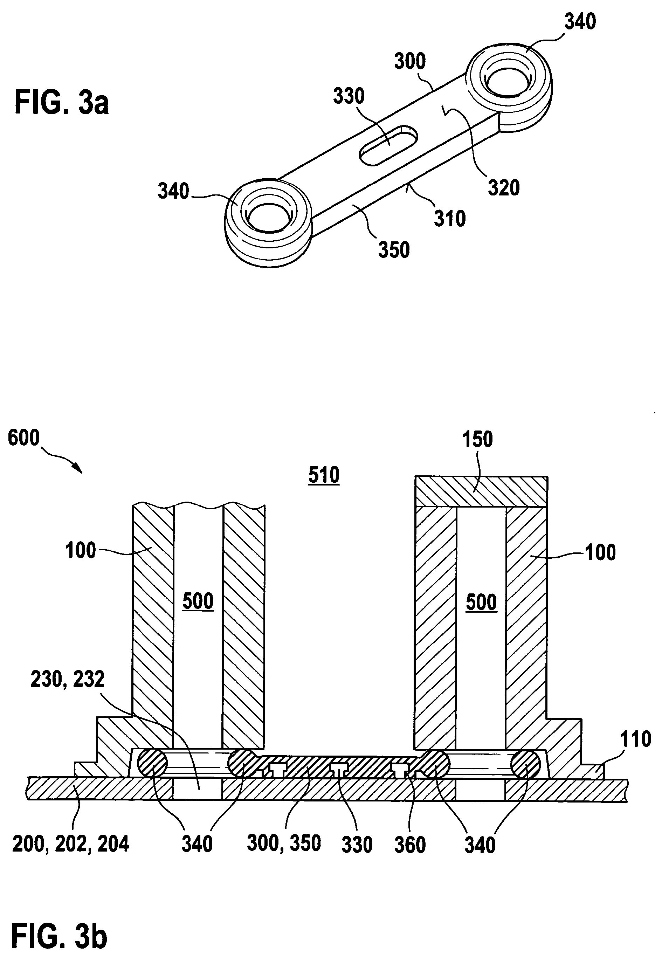

**Fig. 3a** zeigt ein elastisches Dichtungsteil **(300),** das zwei Dichtungsabschnitte **(340)** aufweist. Weiterhin weist das elastische Dichtungsteil einen zwischen den beiden Dichtungsabschnitten **(340)** ausgebildeten und einstückig damit verbundenen Verbindungsabschnitt **(350)** auf. Auf der zweiten Oberfläche **(320)** des Verbindungsabschnitts **(350)** des elastischen Dichtungsteils **(300)** befindet sich eine als Druckkammer wirkende Ausnehmung **(330)** in Napfform, die die Unterdruckhaftung an dem zweiten Bauteil **(200)** bewirkt. Die Dichtungsabschnitte **(340)** sind bevorzugt in Form eines O-Rings ausgebildet.

**Fig. 3b** zeigt einen Querschnitt eines Ausführungsbeispiels einer Vorrichtung **(600)** mit einem elastischem Dichtungsteil **(300)** mit zwei Dichtungsabschnitten **(340)** und einem Verbindungsabschnitt **(350),** sowie zwei erste Bauteile **(100),** die als Rohre ausgebildet sind. Ein erstes Bauteil **(100)** ist dabei als offenes Rohr ausgebildet, ein weiteres erstes Bauteil **(100)** ist als geschlossenes Rohr mit einem Abschluss **(150)** ausgebildet. Die Rohre sind jeweils über einer Öffnung **(230)** im zweiten Bauteil **(200)** angeordnet. Dabei umgibt das elastische Dichtungsteil **(300)** mit dem Dichtungsabschnitt **(340)** umlaufend die Öffnung **(230)** im zweiten Bauteil **(200),** beispielsweise eine Durchgangsöffnung **(232)** in einer Leiterplatte **(204),** und ist zwischen dem ersten Bauteil **(100)** und dem zweiten Bauteil **(200)** angeordnet. Der elastische Dichtabschnitt **(340)** des elastischen Dichtungsteils **(300)** ist in Form eines O-Rings ausgebildet und dichtet die sich so ergebende Kanalstruktur aus der Öffnung **(230)** in dem zweiten Bauteil **(200)** und den als Rohre ausgebildeten ersten Bauteilen **(100)** gegen die Umgebung **(510)** ab. Besonders bevorzugt liegt dabei vor der Montage der ersten Bauteile **(100)** der elastische Dichtungsabschnitt **(340)** durch die Unterdruckhaftung des Verbindungsabschnitts **(350)** des elastischen Dichtungsteils **(300)** verliersicher und positionsgenau um die in dem zweiten Bauteil **(200)** angeordneten Öffnungen **(230)** an. Somit wird eine sichere Abdichtung erzielt und gleichzeitig ist eine die Positionierung unterstützende Geometrie für das elastische Dichtungsteil **(300),** wie z.B. eine Nut oder Haltezapfen im ersten oder im zweiten Bauteil **(200)** verzichtbar.

Weitere, hier nicht dargestellte Ausführungsformen können auch nur einen Dichtungsabschnitt **(340),** aber auch drei, vier oder noch mehr Dichtungsabschnitte **(340)** aufweisen, sowie einen, zwei, oder mehrere Ausnehmungen **(330),** die die Unterdruckhaftung bewirken. Die Ausnehmungen **(330)** können dabei in dem wenigstens einen Dichtungsabschnitt **(340)** und/oder in dem wenigstens einen Verbindungsabschnitt **(350)** angeordnet sein. Dabei können die Dichtungsabschnitte **(340)** in Form von O-Ringen ausgebildet sein, die Form des Dichtungsabschnitts **(340)** kann jedoch auch oval, dreieckig, viereckig oder allgemein vieleckig ausgebildet sein. Möglich sind ferner Dichtungsabschnitte **(340),** die in Linienform ausgebildet sind und keine Öffnung aufweisen und als Dichtlippe zwischen zwei Gehäuseabschnitten eine Abdichtung bewirken.

Vorzugsweise wird ein elastisches Dichtungsteil **(300)** verwendet, das aus einem Material besteht, das bei Temperaturen bis +150°C dicht ist gegen Öl und Wasser.

Bevorzugt besteht das elastische Dichtungsteil **(300)** aus Ethylen-Acryl-Kautschuk (AEM) oder aus Polyacrylatkautschuk (ACM) oder aus Silikonkautschuk (VMQ) oder aus Fluorsilikonkautschuk (FVMQ) oder aus Hydriertem Nitrilkautschuk (HNBR) oder aus Ethylen-Propylen-Terpolymer-Kautschuk (EPDM). In einer Ausführungsform besteht das elastische Dichtungsteil **(300)** aus AEM, das sich bevorzugt eignet für den Einsatz in einer Vorrichtung **(600),** die Mineralölen, beispielsweise in Kraftfahrzeugmotoren oder Kraftfahrzeuggetrieben ausgesetzt ist. Bei einer Verwendung der Vorrichtung **(600)** in einer Umgebung aus Mineralöl oder mit Hochdruckadditiven versehenen Mineralölen, beispielsweise in Getrieben, wird das elastische Dichtungsteil **(300)** besonders bevorzugt aus ACM gefertigt. Die Verwendung von VMQ für das elastische Dichtungsteil **(300)** wird bevorzugt bei Anwendungen verwendet, die eine besonders hohe Beständigkeit gegen Heißluft, andere heiße Gase oder Ozon erfordern, wie sie beispielsweise im Abgasstrang von Kraftfahrzeugen vorkommen. Ist eine sehr große Kälte- und Hitzebeständigkeit bei gleichzeitiger Beständigkeit gegen Mineralölprodukte erforderlich (beispielsweise beim Einsatz in Kraftfahrzeugmotoren oder -getrieben), so wird das elastische Dichtungselement **(300)** bevorzugt aus FVMQ gefertigt. Beim Einsatz der Vorrichtung **(600)** mit dem elastischen Dichtungselement **(300)** in einer Umgebung aus heißen Ölen, Wasser oder Brenngasen, beispielsweise im Kühlwasserkreislauf oder im Motorraum eines Kraftfahrzeugs oder im Abgasstrang eines Kraftfahrzeugs wird das elastische Dichtungsteil **(300)** besonders bevorzugt aus HNBR gefertigt und bewirkt so eine beständige Abdichtung der Vorrichtung **(600).** Beim Einsatz des elastischen Dichtungsteils **(300)** in einer Umgebung, die Witterungseinflüssen ausgesetzt ist oder in der Säuren, Laugen, Heißwasser, Ketone oder Bremsflüssigkeit vorkommen (beispielsweise in Bremssystemen) wird als Material für das elastische Dichtungsteil **(300)** besonders bevorzugt EPDM verwendet, um eine dauerhafte Beständigkeit des elastischen Dichtungsteils **(300)** zu erzielen.

Zur Erzielung der Unterdruckhaftung des elastischen Dichtungsteils **(300)** an dem zweiten Bauteil **(200)** wird folgendermaßen vorgegangen. Das elastische Dichtungsteil **(300)** wird mit seiner zweiten Oberfläche **(320)** an das zweite Bauteil **(200),** beispielsweise einen Schaltungsträger **(202),** insbesondere eine Leiterplatte **(204)** oder auch eine Keramik oder dergleichen, angelegt. Das zweite Bauteil **(200)** weist dabei bevorzugt eine ebene und glatte Oberfläche auf, besonders bevorzugt in den Bereichen, in denen das elastische Dichtungsteil **(300)** und/oder die elastischen Ausleger **(400)** zur Anlage kommen. Zu diesem Zeitpunkt herrscht in den Druckkammern, die sich im elastischen Dichtungsteil **(300)** z.B. in Form von Ausnehmungen **(330)** und/oder in den elastischen Auslegern **(400)** befinden, der Umgebungsdruck, insbesondere Atmosphärendruck. Anschließend werden das elastische Dichtungsteil **(300)** und/oder die elastischen Ausleger **(400)** gegen das zweite Bauteil **(200)** angepresst. Durch den somit erzeugten Druck in den Druckkammern verringert sich das Volumen der Druckkammern. Dadurch entweicht an der Grenzfläche zwischen der zweiten Oberfläche **(320)** des elastischen Dichtungsteils **(300)** und dem zweiten Bauteil **(200)** das Gas, insbesondere die Luft, aus den Druckkammern des elastischen Dichtungsteils **(300).** In einem weiteren Schritt wird der Anpressdruck zurückgenommen, das elastische Dichtungsteil **(300)** also relaxiert. Die in Folge der Materialelastizität des elastischen Dichtungsteils **(300)** erzeugte Rückstellkraft bewirkt eine Vergrößerung des Volumens der Druckkammern des elastischen Dichtungsteils **(300).** Gleichzeitig liegt die zweite Oberfläche **(320)** des elastischen Dichtungsteils **(300),** insbesondere in den Bereichen der Druckkammern dicht am zweiten Bauteil **(200)** an. Die Abdichtung kann dabei durch Dichtlippen, die an den als Druckkammern wirkenden Ausnehmungen **(340)** in der zweiten Oberfläche **(320)** des elastischen Dichtungsteils **(300)** festgelegt sind, begünstigt werden. Da wegen der Dichtheit kein Gas (z.B. Luft) in die Druckkammern einströmen kann, wird durch die Volumenvergrößerung ein Unterdruck (bezogen auf den Umgebungsdruck) in den Druckkammern erzeugt, der die Unterdruckhaftung des elastischen Dichtungsteils **(300)** und/oder der Ausleger **(400)** an dem zweiten Bauteil bewirkt.

Die Vorrichtung **(600)** kann beispielsweise in Steuergeräten für eine Getriebesteuerung oder eine Motorsteuerung oder eine Klimagerätesteuerung eingesetzt werden, ohne auf solche Steuergeräte beschränkt zu sein. Die Vorrichtung **(600)** weist dabei bevorzugt eine wenigstens einlagige Leiterplatte **(204)** oder eine wenigstens einlagige Keramik als Schaltungsträger **(202)** der Getriebe- oder Motor- oder Klimagerätesteuerschaltung auf. Sie kann bevorzugt einen Stecker oder eine Steckverbindung aufweisen zur elektrischen Verbindung der Schaltung mit außerhalb des Steuergerätgehäuses angeordneten Komponenten, wie z.B. Aktuatoren, Sensoren, Steckern, eletronische Auswerteschaltungen dun dergleichen. Die Vorrichtung kann dabei angeordnet sein in einer Umgebung aus Fluiden, wie z.B. Öl (beispielsweise Motoröl, Getriebeöl und dergleichen) oder Wasser mit und ohne Additiven (z.B. Kühlwasser) oder Gasen (beispielsweise Abgase im Abgasstrang, Luft im Ansaugstutzen, Kühlmittelgasen wie z.B. CO2 in Klimageräten und dergleichen).

## Patentansprüche

1. Vorrichtung (600), insbesondere für ein elektronisches Steuergerät, mit wenigstens einem ersten Bauteil (100) und mit wenigstens einem zweiten Bauteil (200) und mit wenigstens einem zwischen dem wenigstens einen ersten Bauteil (100) und dem wenigstens einen zweiten Bauteil (200) angeordneten elastischen Dichtungsteil (300), wobei das erste Bauteil (100) an einer ersten Oberfläche (310) des wenigstens einen elastischen Dichtungsteils (300) anliegt und eine zweite Oberfläche (320) des wenigstens einen elastischen Dichtungsteils (300) an dem zweiten Bauteil (200) anliegt, wobei das wenigstens eine elastische Dichtungsteil (300) mit Mitteln zur Erzielung einer Unterdruckhaftung des wenigstens einen elastischen Dichtungsteils (300) an dem zweiten Bauteil (200) versehen ist,
**dadurch gekennzeichnet, dass** das Dichtungsteil (300) wenigstens einen Dichtungsabschnitt (340) und wenigstens einen elastischen Ausleger (400) aufweist, wobei der wenigstens eine Dichtungsabschnitt (340) in einem Dichtungsbereich zwischen dem ersten Bauteil (100) und dem zweiten Bauteil (200) anliegt und der wenigstens eine elastische Ausleger (400) außerhalb des Dichtungsbereichs an dem zweiten Bauteil (200) zur Anlage kommt und die Mittel zur Erzielung einer Unterdruckanhaftung an dem wenigstens einen elastischen Ausleger (400) des elastischen Dichtungsteils (300) angeordnet sind.

2. Vorrichtung nach Anspruch 1, **dadurch gekennzeichnet, dass** die Mittel zur Erzielung einer Unterdruckhaftung wenigstens eine eine Druckkammer bildende Ausnehmung (330) aufweisen, in der ein Unterdruck erzeugbar ist, durch den das wenigstens eine elastische Dichtungsteil (300) an dem zweiten Bauteil (200) anhaftet.

3. Vorrichtung nach Anspruch 2, **dadurch gekennzeichnet, dass** der Unterdruck in der wenigstens einen Druckkammer durch Anpressen und Relaxieren des elastischen Dichtungsteils (300) erzeugbar ist.

4. Vorrichtung nach Anspruch 2, **dadurch gekennzeichnet, dass** sich die wenigstens eine Ausnehmung (330) in der zweiten Oberfläche (320) des elastischen Dichtungsteils (300) befindet.

5. Vorrichtung nach einem der Ansprüche 1 bis 4, **dadurch gekennzeichnet, dass** das erste Bauteil (100) ein Gehäusedeckel ist und das zweite Bauteil (200) ein Schaltungsträger, insbesondere eine Leiterplatte ist oder dass das erste Bauteil (100) ein Schaltungsträger, insbesondere eine Leiterplatte ist und das zweite Bauteil (200) ein Gehäusedeckel ist.

6. Vorrichtung nach einem der Ansprüche 1 bis 4, **dadurch gekennzeichnet, dass** das erste Bauteil (100) ein wenigstens eine offene Seite aufweisendes Rohr oder ein Sensorelement ist und das zweite Bauteil (200) eine ebene Fläche, insbesondere eine ebene Fläche mit wenigstens einer vom elastischen Dichtungsteil (300) umgebenen Öffnung (230) ist oder dass das erste Bauteil (100) eine ebene Fläche, insbesondere eine ebene Fläche mit wenigstens einer vom elastischen Dichtungsteil (300) umgebenen Öffnung (230) ist und das zweite Bauteil (200) ein wenigstens eine offene Seite aufweisendes Rohr oder ein Sensorelement ist.

7. Vorrichtung nach einem der Ansprüche 1 bis 4, **dadurch gekennzeichnet, dass** das elastische Dichtungsteil (300) mit wenigstens einem umlaufenden Dichtungsabschnitt (340) ausgebildet ist und einen zwischen dem ersten Bauteil (100) und dem zweiten Bauteil (200) ausgebildeten Innenraum, insbesondere einen Gehäuseinnenraum (500), nach außen abdichtet.

8. Vorrichtung nach den Ansprüchen 1 bis 7, **dadurch gekennzeichnet, dass** das elastische Dichtungsteil (300) aus einem Material besteht, das bei Temperaturen bis +150°C dicht ist gegen ÖI und Wasser, insbesondere aus Ethylen-Acryl-Kautschuk (AEM) oder aus Polyacrylatkautschuk (ACM) oder aus Silikonkautschuk (VMQ) oder aus Fluorsilikonkautschuk (FVMQ) oder aus Hydriertem Nitrilkautschuk (HNBR) oder aus EthylenPropylen-Terpolymer-Kautschuk (EPDM).

9. Verfahren zur Herstellung einer Vorrichtung (600), wobei das Verfahren folgende Schritte umfasst:
-- Bereitstellung eines ersten Bauteils (100),
-- Bereitstellung eines zweiten Bauteils (200),
-- Bereitstellen eines elastischen Dichtungsteils (300) mit einer ersten Oberfläche (310) und einer davon abgewandten zweiten Oberfläche (320),
-- Anlegen der zweiten Oberfläche (320) des elastischen Dichtungsteils (300) an das zweite Bauteil (200),
-- Aufsetzen des ersten Bauteils (100) auf die erste Oberfläche (310) des elastischen Dichtungsteils (300),
-- Dichtpressen des wenigstens einen elastischen Dichtungsteils (300), zwischen dem ersten Bauteil (100) und dem zweiten Bauteil (200),
wobei das wenigstens eine elastische Dichtungsteil (300) mit Mitteln zur Erzielung einer Unterdruckhaftung des wenigstens einen elastischen Dichtungsteils (300) an dem zweiten Bauteil (200) versehen ist,
**dadurch gekennzeichnet, dass** das wenigstens eine elastische Dichtungsteil (300) vor dem Schritt des Aufsetzens des ersten Bauteils (100) an dem zweiten Bauteil (200) zur Haftung gebracht wird, indem das wenigstens eine elastische Dichtungsteil (300) auf das zweite Bauteil (200) zunächst angepresst und anschließend relaxiert wird und dass das Dichtungsteil (300) wenigstens einen Dichtungsabschnitt (340) und wenigstens einen elastischen Ausleger (400) aufweist, wobei der wenigstens eine Dichtungsabschnitt (340) in einem Dichtungsbereich zwischen dem ersten Bauteil (100) und dem zweiten Bauteil (200) anliegt und der wenigstens eine elastische Ausleger (400) außerhalb des Dichtungsbereichs an dem zweiten Bauteil (200) zur Anlage kommt und die Mittel zur Erzielung einer Unterdruckanhaftung an dem wenigstens einen elastischen Ausleger (400) des elastischen Dichtungsteils (300) angeordnet sind.

10. Verfahren nach Anspruch 9, **dadurch gekennzeichnet, dass** beim Anpressen des wenigstens einen elastischen Dichtungsteils (300) auf das zweite Bauteil(200) die Luft aus wenigstens einer eine Druckkammer bildenden Ausnehmung (330) des Dichtungsteils (300) herausgedrückt wird und anschließend die wenigstens eine Ausnehmung (330) durch das elastische Dichtungsteil und das daran anliegende zweite Bauteil (200) derart abgedichtet ist, dass sich in der Ausnehmung (330) beim Relaxieren des wenigstens einen elastischen Dichtungsteils (300) ein Unterdruck bildet, der die Haftung des wenigstens einen elastischen Dichtungsteils (300) an dem zweiten Bauteils (200) bewirkt.

## Claims

1. Apparatus (600), in particular for an electronic control device, having at least one first component (100) and having at least one second component (200) and having at least one elastic sealing part (300) which is arranged between the at least one first component (100) and the at least one second component (200), wherein the first component (100) rests against a first surface (310) of the at least one elastic sealing part (300) and a second surface (320) of the at least one elastic sealing part (300) rests against the second component (200), wherein the at least one elastic sealing part (300) is provided with means for achieving vacuum adhesion of the at least one elastic sealing part (300) to the second component (200), **characterized in that** the sealing part (300) has at least one sealing section (340) and at least one elastic extension arm (400), wherein the at least one sealing section (340) rests in a sealing region between the first component (100) and the second component (200), and the at least one elastic extension arm (400) comes to rest against the second component (200) outside the sealing region, and the means for achieving vacuum adhesion is arranged on the at least one elastic extension arm (400) of the elastic sealing part (300).

2. Apparatus according to Claim 1, **characterized in that** the means for achieving vacuum adhesion have at least one recess (330) which forms a pressure chamber and in which a vacuum can be generated, the at least one elastic sealing part (300) adhering to the second component (2) due to the said vacuum.

3. Apparatus according to Claim 2, **characterized in that** the vacuum in the at least one pressure chamber can be generated by pressing and relaxing the elastic sealing part (300).

4. Apparatus according to Claim 2, **characterized in that** the at least one recess (330) is located in the second surface (320) of the elastic sealing part (300).

5. Apparatus according to one of Claims 1 to 4, **characterized in that** the first component (100) is a housing cover and the second component (2) is a circuit carrier, in particular a printed circuit board, or **in that** the first component (100) is a circuit carrier, in particular a printed circuit board, and the second component (200) is a housing cover.

6. Apparatus according to one of Claims 1 to 4, **characterized in that** the first component (100) is a pipe which has at least one open side or is a sensor element and the second component (200) is a flat face, in particular a flat face with at least one opening (230) which is surrounded by the elastic sealing part (300), or **in that** the first component (100) is a flat face, in particular a flat face with at least one opening (230) which is surrounded by the elastic sealing part (300), and the second component (200) is a pipe which has at least one open side or is a sensor element.

7. Apparatus according to one of Claims 1 to 4, **characterized in that** the elastic sealing part (300) is formed with at least one circumferential sealing section (340) and seals off an interior space which is formed between the first component (100) and the second component (200), in particular a housing interior space (500), to the outside.

8. Apparatus according to Claims 1 to 7, **characterized in that** the elastic sealing part (300) is composed of a material which is impervious to oil and water at temperatures of up to +150°C, in particular is composed of ethylene acrylic elastomer (AEM) or is composed of polyacrylate rubber (ACM) or is composed of silicone rubber (VMQ) or is composed of fluorosilicone rubber (FVMQ) or is composed of hydrogenated nitrile rubber (HNBR) or is composed of ethylene propylene terpolymer rubber (EPDM).

9. Method for producing an apparatus (600), wherein the method comprises the following steps:
- providing a first component (100),
- providing a second component (200),
- providing an elastic sealing part (300) with a first surface (310) and a second surface (320) which is averted from the said first surface,
- placing the second surface (320) of the elastic sealing part (300) against the second component (200),
- mounting the first component (100) onto the first surface (310) of the elastic sealing part (300),
- pressing the at least one elastic sealing part (300) in a sealing manner between the first component (100) and the second component (200),
wherein the at least one elastic sealing part (300) is provided with means for achieving vacuum adhesion of the at least one elastic sealing part (300) to the second component (200),
**characterized in that**, before the step of mounting the first component (100), the at least one elastic sealing part (300) is attached by adhesion to the second component (200) by the at least one elastic sealing part (300) initially being pressed onto the second component (200) and then being relaxed,
and **in that** the sealing part (300) has at least one sealing section (340) and at least one elastic extension arm (400), wherein the at least one sealing section (340) rests in a sealing region between the first component (100) and the second component (200), and the at least one elastic extension arm (400) comes to rest against the second component (200) outside the sealing region, and the means for achieving vacuum adhesion are arranged on the at least one elastic extension arm (400) of the elastic sealing part (300).

10. Method according to Claim 9, **characterized in that**, when the at least one elastic sealing part (300) is pressed onto the second component (200), the air is pushed out of at least one recess (330), which forms a pressure chamber, of the sealing part (300), and then the at least one recess (330) is sealed off by the elastic sealing part and the second component (200), which rests against it, in such a way that a vacuum which causes the at least one elastic sealing part (300) to adhere to the second component (200) forms in the recess (330) when the at least one elastic sealing part (300) relaxes.

## Revendications

1. Ensemble (600), en particulier pour appareil électronique de commande, présentant au moins un premier composant (100) et au moins un deuxième composant (200) ainsi qu'au moins une pièce élastique d'étanchéité (300) disposée entre le ou les premiers composants (100) et le ou les deuxièmes composants (200), le premier composant (100) reposant contre une première surface (310) de la ou des pièces élastiques d'étanchéité (300) et une deuxième surface (320) de la ou des pièces élastiques d'étanchéité (300) reposant contre le deuxième composant (200),
la ou les pièces élastiques d'étanchéité (300) étant dotées de moyens permettant d'obtenir une adhérence en dépression de la ou des pièces élastiques d'étanchéité (300) sur le deuxième composant (200), **caractérisé en ce que**
la pièce d'étanchéité (300) présente au moins une section d'étanchéité (340) et au moins un prolongement élastique (400),
**en ce que** la ou les sections d'étanchéité (340) reposent dans une zone d'étanchéité située entre le premier composant (100) et le deuxième composant (200),
**en ce que** le ou les prolongements élastiques (400) viennent se placer contre le deuxième composant (200) à l'extérieur de la zone d'étanchéité et
**en ce que** les moyens permettant d'obtenir une adhérence en dépression sont disposés sur le ou les prolongements élastiques (400) de la pièce élastique d'étanchéité (300).

2. Ensemble selon la revendication 1, **caractérisé en ce que** les moyens permettant d'obtenir une adhérence en dépression présentent au moins une découpe (330) qui forme une chambre sous pression dans laquelle peut être formée une dépression par laquelle la ou les pièces élastiques d'étanchéité (300) adhèrent sur le deuxième composant (200).

3. Ensemble selon la revendication 2, **caractérisé en ce que** la dépression peut être formée dans la ou les chambres sous pression par compression et relaxation de la pièce élastique d'étanchéité (300).

4. Ensemble selon la revendication 2, **caractérisé en ce que** la ou les découpes (330) sont situées dans la deuxième surface (320) de la pièce élastique d'étanchéité (300).

5. Ensemble selon l'une des revendications 1 à 4, **caractérisé en ce que** le premier composant (100) est un couvercle de boîtier et le deuxième composant (200) un support de circuit, en particulier une carte de circuit, ou **en ce que** le premier composant (100) est un support de circuit, en particulier une carte de circuit, et le deuxième composant (200) un couvercle de boîtier.

6. Ensemble selon l'une des revendications 1 à 4, **caractérisé en ce que** le premier composant (100) est un tube ou un élément de capteur qui présente au moins un côté ouvert et le deuxième composant (200) est une surface plane, en particulier une surface plane qui présente au moins une ouverture (230) entourée par la pièce élastique d'étanchéité (300), ou **en ce que** le premier composant (100) est une surface plane, en particulier une surface plane présentant au moins une ouverture (230) entourée par la pièce élastique d'étanchéité (300) et le deuxième composant (200) un tube ou un élément de capteur présentant au moins un côté ouvert.

7. Ensemble selon l'une des revendications 1 à 4, **caractérisé en ce que** la pièce élastique d'étanchéité (300) est configurée avec au moins une section périphérique d'étanchéité (340) et forme hermétiquement vis-à-vis de l'extérieur un espace intérieur, en particulier un espace intérieur (500) de boîtier, formé entre le premier composant (100) et le deuxième composant (200).

8. Ensemble selon l'une des revendications 1 à 7, **caractérisé en ce que** la pièce élastique d'étanchéité (300) est constituée d'un matériau étanche aux huiles et à l'eau à des températures pouvant atteindre +150°C, en particulier en caoutchouc d'éthylène-acryle (AEM), en caoutchouc au polyacrylate (ACM), en caoutchouc au silicone (VMQ), en caoutchouc au fluorosilicone (FVMQ), en caoutchouc nitrile hydrogéné (HNBR) ou en caoutchouc de terpolymère d'éthylène et de propylène (EPDM).

9. Procédé de fabrication d'un ensemble (600), le procédé comportant les étapes suivantes :
préparer un premier composant (100),
préparer un deuxième composant (200),
préparer une pièce élastique d'étanchéité (300) qui présente une première surface (310) et une deuxième surface (320) non tournée vers la première,
placer la deuxième surface (320) de la pièce élastique d'étanchéité (300) sur le deuxième composant (200),
placer le premier composant (100) sur la première surface (310) de la pièce élastique d'étanchéité (300), comprimer la ou les pièces élastiques d'étanchéité (300) entre le premier composant (100) et le deuxième composant (200),
la ou les pièces élastiques d'étanchéité (300) étant dotées de moyens permettant d'obtenir une adhérence en dépression de la ou des pièces élastiques d'étanchéité (300) sur le deuxième composant (200), **caractérisé en ce que**
avant l'étape de placement du premier composant (100) sur le deuxième composant (200), la ou les pièces élastiques d'étanchéité (300) sont amenées à adhérer en repoussant d'abord la ou les pièces élastiques d'étanchéité (300) contre le deuxième composant (200) pour être ensuite relâchées,
**en ce que** la pièce d'étanchéité (300) présente au moins une section d'étanchéité (340) et au moins un prolongement élastique (400),
**en ce que** la ou les sections d'étanchéité (340) reposent dans une zone d'étanchéité située entre le premier composant (100) et le deuxième composant (200),
**en ce que** le ou les prolongements élastiques (400) viennent se placer contre le deuxième composant (200) à l'extérieur de la zone d'étanchéité et
**en ce que** les moyens permettant d'obtenir une adhérence en dépression sont disposés sur le ou les prolongements élastiques (400) de la pièce élastique d'étanchéité (300).

10. Procédé selon la revendication 9, **caractérisé en ce que** lorsque la ou les pièces élastiques d'étanchéité (300) sont repoussées contre le deuxième composant (200), l'air est refoulé hors de la ou des découpes (330) de la pièce d'étanchéité (300) qui forment une chambre sous pression, la ou les découpes (330) étant ensuite fermées hermétiquement par la pièce élastique d'étanchéité et le deuxième composant (200) placé contre elle de telle sorte que lors de la relaxation de la ou des pièces élastiques d'étanchéité (300) se forme dans la découpe (330) une dépression qui a pour effet l'adhérence de la ou des pièces élastiques d'étanchéité (300) sur le deuxième composant (200).
